(19) Europäisches Patentamt
European Patent Office
Office européen des brevets

(11) **EP 3 890 032 A1**

(12) **EUROPEAN PATENT APPLICATION**

(43) Date of publication:
06.10.2021 Bulletin 2021/40

(51) Int Cl.:
*H01L 31/048* (2014.01)

(21) Application number: 20166956.1

(22) Date of filing: 31.03.2020

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Borealis AG**
**1220 Vienna (AT)**

(72) Inventors:
• **HELLSTROEM, Stefan**
**44486 Stenungsund (SE)**

• **COSTA, Francis**
**4021 Linz (AT)**
• **BROEDERS, Bert**
**3580 Beringen (BE)**
• **ODERKERK, Jeroen**
**44486 Stenungsund (SE)**
• **YALALOV, Denis**
**44486 Stenungsund (SE)**

(74) Representative: **Maiwald Patent- und
Rechtsanwaltsgesellschaft mbH
Elisenhof
Elisenstraße 3
80335 München (DE)**

(54) **PHOTOVOLTAIC MODULE WITH INCREASED RESISTANCE AGAINST POTENTIAL INDUCED DEGRADATION**

(57)     The present invention relates to a photovoltaic module comprising a protective front layer element, an encapsulation layer element, a photovoltaic cell element and a protective back layer element, whereby at least one of the protective elements comprises glass; wherein the encapsulation layer element comprises a polymer composition (I) comprising at least the following components: (A) 90 to 99.8 wt.-% based on the overall weight of the polymer composition (I) of a polymer selected from a polyolefin elastomer or a polymer of ethylene (a) selected from (a1) a copolymer of ethylene which bears functional groups containing units; (a2) a copolymer of ethylene comprising one or more polar comonomer unit(s) selected from (C1-C6)-alkyl acrylate or (C1-C6)-alkyl (C1-C6)-alkyl acrylate comonomer units, and optionally bears functional groups containing units different from said polar comonomer unit(s); (a3) a copolymer of ethylene comprising one or more alpha-olefin comonomer unit(s); and optionally bears functional groups containing units different from said polar comonomer unit(s) of polymer (a2); or mixtures thereof; and (b) silane group(s) containing units; (B) 0.2 to 10 wt.-% based on the overall weight of the polymer composition (I) of a copolymer of ethylene, which bears functional group containing units originating from at least one unsaturated carboxylic acid and/or its anhydrides, metal salts, esters, amides or imides and mixtures thereof, whereby component (B) is different from component (A); whereby components (A) and (B) add up to 100 wt.-%. Furthermore, the present invention refers to the use of an encapsulation layer element comprising polymer composition (I) according to the invention for increasing the $P_{max}$ determined after 96 h according to IEC 60904, by applying the foil method with a temperature of 85°C and relative humidity of 60 % and a potential difference of 1500 V, of a photovoltaic module comprising besides the encapsulation layer element a protective front layer element, a photovoltaic cell element and a protective back element, whereby at least one of the protective elements comprises glass.

**EP 3 890 032 A1**

**Description**

The present invention relates to a photovoltaic module comprising an encapsulation layer element comprising a specific polymer composition (I). Furthermore, the present invention refers to the use of an encapsulation layer element comprising the specific polymer composition (I) for increasing the long-term maximum power output ($P_{max}$) of a photovoltaic module.

Potential Induced Degradation (PID) is an undesirable effect on solar modules. PID, as the name implies, can occur when the module's voltage potential and leakage current drive ion mobility within the module between the semiconductor material and other elements of the module (e.g. glass, mount and frame), thus causing the module's power output capacity to degrade, in some cases significantly.

Several attempts to increase the PID resistance are already known from the prior art.

CN 104319313 A refers to a method for preventing PID of a polycrystalline silicon solar cell component. The method comprises the following steps: heating a high molecular insulating material into a liquid molten state and adsorbing the high molecular insulating fluid material by using sponge; uniformly coating a layer of insulating fluid material at the edge of a selected cell by using the sponge adsorbing the high molecular insulating fluid material; placing the coated cell in a carrier box for standing and irradiating by using ultraviolet to cure the insulating material on the surface of the cell; packaging the cell component after the insulating material on the surface of the cell is cured.

US 2015/287845 A1 relates to a solar cell structure including a substrate, a doped emitter layer on a front side of the substrate, and an anti-reflection layer covering the doped emitter layer. The anti-reflection layer is a multi-layer structure including at least one ion diffusion barrier such as amorphous silicon film or a silicon-rich silicon nitride film directly covering the doped emitter layer.

WO 2017/049798 A1 refers to a PID-resistant and wind sand resistant crystalline silicon solar cell assembly comprising a solar cell string, polyolefin layers stacked at two sides of the solar cell string, a front plate glass layer stacked on one of the polyolefin layers, a back plate stacked on another polyolefin layer, a frame used for clamping the back plate and the front plate glass layer, and a connection box mounted on the back plate and used for connecting the solar cell string and an external line.

With the trend towards thin photovoltaic modules the thickness of the encapsulation layer elements has developed to below 0.5 mm. However, photovoltaic modules comprising a front and/or rear encapsulation layer of more than 0.5 mm, such as 0.6 mm to 2.0 mm show an increased resistance to PID. WO 2017/076629 A1 discloses materials suitable for manufacturing encapsulation layers having the required thickness for obtaining improved PID-resistance.

WO 2018/141672 A1 relates to an article comprising a layer element of at least two layers. The article is preferably a film or photovoltaic module, preferably a photovoltaic module. The materials used in the encapsulation layer are also suited for increasing the PID-resistance.

WO 2019/173262 A1 refers to a photovoltaic module comprising an encapsulant layer and a solar cell assembly, said encapsulant layer comprising an encapsulant composition, comprising a blend of a copolymer of ethylene and vinyl acetate (EVA) and an anti-potential-induced degradation (PID) enhancing copolymer A. The claimed solution has the disadvantage that the anti-potential-induced degradation enhancing copolymer A needs to be present in amounts of >10 wt.-% to maintain the maximum power output at > 98 % after 96 hours.

However, the photovoltaic modules known form the prior art still do not show acceptable PID resistance. Starting therefrom it was an objective of the present invention to provide photovoltaic modules with increased PID resistance allowing to obtain a high long-term $P_{max}$, such as after 96 hours.

These objectives have been solved by the photovoltaic module according to claim 1 comprising a protective front layer element, an encapsulation layer element, a photovoltaic cell element and a protective back layer element, whereby at least one of the protective elements comprises glass;

wherein the encapsulation layer element comprises a polymer composition (I) comprising at least the following components:

(A) 90 to 99.8 wt.-% based on the overall weight of the polymer composition (I) of a polymer selected from a polyolefin elastomer or a polymer of ethylene (a) selected from

(a1) a copolymer of ethylene which bears functional groups containing units;
(a2) a copolymer of ethylene comprising one or more polar comonomer unit(s) selected from (C1-C6)-alkyl acrylate or (C1-C6)-alkyl (C1-C6)-alkyl acrylate comonomer units, and optionally bears functional groups containing units different from said polar comonomer unit(s);
(a3) a copolymer of ethylene comprising one or more alpha-olefin comonomer unit(s); and optionally bears functional groups containing units different from said polar comonomer unit(s) of polymer (a2); or mixtures thereof; and
(b) silane group(s) containing units;

(B) 0.2 to 10 wt.-% based on the overall weight of the polymer composition (I) of a copolymer of ethylene, which bears functional group containing units originating from at least one unsaturated carboxylic acid and/or its anhydrides, metal salts, esters, amides or imides and mixtures thereof, whereby component (B) is different from component (A);

whereby components (A) and (B) add up to 100 wt.-%.

Advantageous embodiments of the photovoltaic module in accordance with the present invention are specified in the dependent claims 2 to 14. Claim 15 of the present invention refers to the use of an encapsulation layer element comprising polymer composition (I) according to any one of claims 1 to 10 or 14 for retaining the $P_{max}$ determined after 96 h according to IEC 60904, by applying the foil method with a temperature of 85°C and relative humidity of 60 % and a potential difference of 1500 V, of a photovoltaic module comprising besides the encapsulation layer element a protective front layer element, a photovoltaic cell element and a protective back element, whereby at least one of the protective elements comprises glass.

### Definitions

Indications of Quantity

The polymer composition (I) in the encapsulant layer element in accordance with the present invention mandatorily comprises the components (A) and (B) and optionally additives (C). The requirement applies here that the components (A) and (B) and if present the additives (C) add up to 100 wt.-% in sum. The fixed ranges of the indications of quantity for the individual components (A) and (B) and optionally the additives (C) are to be understood such that an arbitrary quantity for each of the individual components can be selected within the specified ranges provided that the strict provision is satisfied that the sum of all the components (A), (B) and optionally the additives (C) add up to 100 wt.-%.

An "element" in connection with the photovoltaic module of the present invention means a self-contained unit of the photovoltaic module. The elements of the photovoltaic module are preferably connected to form the photovoltaic module by lamination.

"Front" in connection with the photovoltaic module of the present invention means the planar side of the photovoltaic module facing towards the solar irradiation.

"Back" in connection with the photovoltaic module of the present invention means the planar side of the photovoltaic module facing away from the solar irradiation.

The "photovoltaic cell element" is the element of the photovoltaic module which converts the energy of light directly into electricity by the photovoltaic effect. Silicon based material, e.g. crystalline silicon, is a non-limiting example of materials used in photovoltaic cell(s). Crystalline silicon material can vary with respect to crystallinity and crystal size, as well known to a skilled person. Alternatively, the photovoltaic cell element can be a substrate layer on one surface of which a further layer or deposit with photovoltaic activity is subjected, for example a glass layer, wherein on one side thereof an ink material with photovoltaic activity is printed, or a substrate layer on one side thereof a material with photovoltaic activity is deposited. For instance, in well-known thin film solutions of photovoltaic cell elements e.g. an ink with photovoltaic activity is printed on one side of a substrate, which is typically a glass substrate.

"Photovoltaic cell(s)" means herein a layer element of photovoltaic cells, as explained above, together with connectors.

"Rigid" in connection with the photovoltaic module of the present invention means that the element is stiff and cannot be bended in a manner as flexible elements, and if bended, then typically the integrity of the element typically breaks easily causing permanent fractures, as is not the case with a flexible element. A skilled person can easily differentiate a rigid and flexible layer element.

A polymer of ethylene herein denotes a polymer which comprises a weight majority of ethylene monomer units, i.e. more than 50 wt.-% of ethylene monomer units.

"Comonomer" herein refers to copolymerisable comonomer units.

A "silane group(s) containing unit" herein refers to a chemical moiety which comprises one or more silyl groups. The "silane group(s) containing unit" can be part of a polymer or chemical compound which is different from the polymer of ethylene (a). The silane group(s) containing polymer or compound is then added to the polymer composition by blending with the polymer of ethylene (a). The "silane group(s) containing unit" can be part of the polymer of ethylene (a). Thereby, the "silane group(s) containing unit" can be a copolymerizable comonomer unit or a unit which can be chemically grafted onto the polymer of ethylene (a).

A "functional group(s) containing unit" herein refers to a substituent or chemical moiety which is responsible for the characteristic chemical reaction of the accordant polymer or compound.

The retained $P_{max}$ is determined according to IEC 60904. $P_{max}$ is the power that the PV module generates from a flash pulse of 1000 W/m$^2$ at standard test conditions (STC). From the IV-curve generated at the flash test, $P_{max}$ is obtained from the equation below where $I_{sc}$ is the short-circuit current, $V_{oc}$ is the open-circuit voltage and FF is the fill factor.

$$P_{max} = V_{oc} * I_{sc} * FF$$

Where the term "comprising" is used in the present description and claims, it does not exclude other non-specified elements of major or minor functional importance. For the purposes of the present invention, the term "consisting of" is considered to be a preferred embodiment of the term "comprising of". If hereinafter a group is defined to comprise at least a certain number of embodiments, this is also to be understood to disclose a group, which preferably consists only of these embodiments.

Whenever the terms "including" or "having" are used, these terms are meant to be equivalent to "comprising" as defined above.

Where an indefinite or definite article is used when referring to a singular noun, e.g. "a", "an" or "the", this includes a plural of that noun unless something else is specifically stated.

Component (A)

The polymer composition (I) in accordance with the present invention comprises as component (A) from 90 to 99.8 wt.-% based on the overall weight of the polymer composition (I) of a polymer selected from a polyolefin elastomer or a polymer of ethylene (a) selected from (a1) a copolymer of ethylene which bears functional groups containing units; (a2) a copolymer of ethylene comprising one or more polar comonomer unit(s) selected from (C1-C6)-alkyl acrylate or (C1-C6)-alkyl (C1-C6)-alkyl acrylate comonomer units, and optionally bears functional groups containing units different from said polar comonomer unit(s); (a3) a copolymer of ethylene comprising one or more alpha-olefin comonomer unit(s); and optionally bears functional groups containing units different from said polar comonomer unit(s) of polymer (a2); or mixtures thereof; and (b) silane group(s) containing units.

Preferred embodiments of component (A) will be discussed in the following.

A preferred embodiment in accordance with the present invention stipulates that component (A) comprises and preferably consists of (a1) a copolymer of ethylene which bears silane group(s) containing units (b) as functional groups containing units; or (a2) a copolymer of ethylene comprising one or more polar comonomer unit(s) selected from (C1-C6)-alkyl acrylate or (C1-C6)-alkyl (C1-C6)-alkyl acrylate comonomer units, and optionally bears silane group(s) containing units (b) as functional groups containing units different from said polar comonomer unit(s); preferably component (A) is (a1) a copolymer of ethylene which bears silane group(s) containing units (b) as functional groups containing units; or (a2) a polymer of ethylene comprising methyl acrylate comonomer units and bears silane group(s) containing units (b) as functional groups containing units different from said polar comonomer unit(s); and more preferably component (A) is a copolymer of ethylene (a1) with vinyl trimethoxysilane comonomer units or a terpolymer of ethylene (a2) with methyl acrylate comonomer units and vinyl trimethoxysilane comonomer units.

According to one further preferred embodiment in accordance with the present invention component (A) a terpolymer of ethylene (a2) with methyl acrylate comonomer units and vinyl trimethoxysilane comonomer units. The content of the methyl acrylate comonomer units present in the polymer of ethylene (a2) is preferably in the range of 4.5 to 18 mol-%, more preferably of 5.0 to 18.0 mol-%, still more preferably of 6.0 to 18.0 mol-%, even more preferably of 6.0 to 16.5 mol-%, even still more preferably of 6.8 to 15.0 mol-%, most preferably of 7.0 to 13.5 mol-%. The content of the vinyl trimethoxysilane comonomer units (b) present in the polymer of ethylene (a2) is preferably in the range of 0.01 to 1.00 mol-%, more preferably of 0.05 to 0.80 mol-% and still more preferably of 0.10 to 0.60 mol-%.

In another preferred embodiment according to the present invention component (A) is different from a polyolefin elastomer.

According to a further preferred embodiment in accordance with the present invention the content of component (A) in polymer composition (I) is in the range of 95.0 to 99.5 wt.%, preferably in the range of 97.0 to 99.0 wt.-% and more preferably from 98.0 to 99.0 wt.-% based on the overall weight of the polymer composition (I).

According to another preferred embodiment of the present invention the alpha-olefin comonomer(s) of polymer of ethylene (a3) are preferably selected from alpha olefins having from 3 to 12 carbon atoms, more preferably from alpha olefins having from 4 to 8 carbon atoms, such as 1-butene, 1-hexene or 1-octene.

In still another preferred embodiment the content of alpha-olefin comonomer(s) of polymer of ethylene (a3), is preferably of 4.5 to 18 mol-%, preferably of 5.0 to 18.0 mol-%, preferably of 6.0 to 18.0 mol-%, preferably of 6.0 to 16.5 mol-%, more preferably of 6.8 to 15.0 mol-%, more preferably of 7.0 to 13.5 mol-%.

The silane group(s) containing units (b) and the polymer (a) can be present as separate components, i.e. as blend, in the polymer composition of the invention. Alternatively, the silane group(s) containing units (b) can be present as a comonomer of the polymer (a) or as a compound grafted chemically to the polymer (a). In general, copolymerisation and grafting of the silane group(s) containing units to ethylene are well known techniques and well documented in the polymer field and within the skills of a skilled person.

In case of a blend, the silane group(s) containing units (b) component can be a silane group(s) containing polymer or a silane group(s) containing compound. Said silane group(s) containing compound may, at least partly, be reacted chemically with the polymer (a), e.g. grafted to polymer (a), using optionally e.g. a radical forming agent, such as peroxide. Such chemical reaction may take place before or during the lamination process of the invention.

Preferably the silane group(s) containing units (b) are present (bonded) in the polymer (a). More preferably, the polymer (a) bears functional group(s) containing units, whereby said functional group(s) containing units are said silane group(s) containing units (b). In this embodiment the silane group(s) containing units (b) can be copolymerised or grafted to the polymer (a). Accordingly, the silane group(s) containing units (b) as the preferable functional group(s) containing units are preferably present in said polymer (a) in form of comonomer units or in form of grafted compounds.

In a more preferable embodiment of the present invention, the polymer (a) comprises functional group(s) containing units which are the silane group(s) containing units (b) as comonomer in the polymer (a). The copolymerisation provides more uniform incorporation of the units (b). Moreover, the copolymerisation does not require the use of peroxide which is typically needed for the grafting of said units to polyethylene. It is known that peroxide brings limitations to the choice of MFR of the polymer used as a starting polymer (during grafting the MFR of the polymer decreases since the peroxide not only initiates the grafting but also crosslinks the polymer) for a PV module and the decomposition products formed from peroxide can deteriorate the quality of the polymer.

The silane group(s) containing comonomer unit or compound as the silane group(s) containing units (b) is suitably a hydrolysable unsaturated silane compound represented by the formula

$$R1SiR2qY3-q \qquad (I)$$

wherein

R1 is an ethylenically unsaturated hydrocarbyl, hydrocarbyloxy or (meth)acryloxy hydrocarbyl group,
each R2 is independently an aliphatic saturated hydrocarbyl group,
Y which may be the same or different, is a hydrolysable organic group and
q is 0, 1 or 2.

Special examples of the unsaturated silane compound are those wherein R1 is vinyl, allyl, isopropenyl, butenyl, cyclohexanyl or gamma-(meth)acryloxy propyl; Y is methoxy, ethoxy, formyloxy, acetoxy, propionyloxy or an alkyl- or arylamino group; and R2, if present, is a methyl, ethyl, propyl, decyl or phenyl group.

Further suitable silane compounds or, preferably, comonomers are e.g. gamma-(meth)acryl-oxypropyl trimethoxysilane, gamma(meth)acryloxypropyl triethoxysilane, and vinyl triacetoxysilane, or combinations of two or more thereof.

As a suitable subgroup of unit of formula (I) is an unsaturated silane compound or, preferably, comonomer of formula (II)

$$CH2=CHSi(OA)3 \qquad (II)$$

wherein each A is independently a hydrocarbyl group having 1 to 8 carbon atoms, suitably 1 to 4 carbon atoms.

In one embodiment of silane group(s) containing units (b) of the invention, comonomers/compounds of formula (I), preferably of formula (II), are selected from vinyl trimethoxysilane, vinyl bismethoxyethoxysilane, vinyl triethoxysilane, vinyl trimethoxysilane. Mostly preferred is vinyl trimethoxysilane.

The amount of the silane group(s) containing units (b) present in the polymer (a), is from 0.01 to 1.00 mol-%, suitably from 0.05 to 0.80 mol-%, suitably from 0.10 to 0.60 mol-%, suitably from 0.10 to 0.50 mol-%, when determined according to "Comonomer contents" as described below under "Determination Methods".

The polymer of ethylene (a) preferably has a melt flow rate $MFR_2$ (2.16 kg; 190°C) of less than 20 g/10 min, preferably from 0.1 to 15 g/10 min, more preferably from 0.2 to 13 g/10 min, still more preferably from 0.3 to 13, most preferably from 0.4 to 13 g/10 min.

The density of the polymer of ethylene (a) preferably is higher than 860 $kg/m^3$. Preferably the density is not higher than 970 $kg/m^3$, and more preferably is from 920 to 960 $kg/m^3$, according to ISO 1872-2.

The polymer of ethylene (a) preferably has a Shear thinning index, $SHI_{0.05/300}$, of 30.0 to 100.0, preferably of 40.0 to 80.0, when measured according to "Rheological properties: Dynamic Shear Measurements (frequency sweep measurements)" as described below under "Determination Methods".

The polymer (a) of the polymer composition can be e.g. commercially available or can be prepared according to or analogously to known polymerization processes described in the chemical literature. Further details of the production of ethylene (co)polymers by high pressure radical polymerization can be found i.a. in the Encyclopedia of Polymer Science and Engineering, Vol. 6 (1986), pp 383-410 and Encyclopedia of Materials: Science and Technology, 2001 Elsevier Science Ltd.: "Polyethylene: High-pressure, R. Klimesch, D. Littmann and F.-O. Mähling pp. 7181-7184.

Component (B)

Besides component (A) the polymer composition (I) in accordance with the present invention mandatorily comprises as component (B) from 0.2 to 10 wt.-% based on the overall weight of the polymer composition (I) of a copolymer of ethylene, which bears functional group containing units originating from at least one unsaturated carboxylic acid and/or its anhydrides, metal salts, esters, amides or imides and mixtures thereof, whereby component (B) is different from component (A).

In the following preferred embodiments of component (B) will be discussed.

In a preferred embodiment in accordance with the present invention component (B) is a copolymer of ethylene and a $C_4$ to $C_{10}$ alpha olefin comonomer, preferably a copolymer of ethylene and 1-octene; whereby said copolymer before introducing the functional group has a density in the range of 850 kg/m$^3$ to 920 kg/m$^3$, preferably in the range of 860 to 905 kg/m$^3$ and more preferably in the range of 865 to 900 kg/m$^3$ measured according to ISO 1183.

Another preferred embodiment according to the present invention stipulates that component (B) has an MFR$_2$ in the range of 0.1 to 20.0 g/10 min, preferably in the range of 0.5 to 10 g/10 min and more preferably in the range of 0.5 to 3 g/10 min measured according to ISO 1133 at 190°C and a load of 2.16 kg.

$C_4$ to $C_8$ alpha-olefin comonomers are for example 1-butene, 1-hexene or 1-octene. Preferably, the comonomer is 1-butene or 1-octene, more preferably the comonomer is 1-octene. The amount of comonomer is usually in the range of 20.0 wt.-% to 45.0 wt.-%, depending on the chosen comonomer and the desired density. Suitable copolymers (a) have an ethylene content in the range from 55 to 80 wt.-%, preferably from 58 to 78 wt.-% and more preferably from 60 to 75 wt.-%.

According to a further preferred embodiment of the present invention the copolymer of ethylene for component (B) is a copolymer of ethylene and methyl acrylate or a copolymer of ethylene and butyl acrylate.

In still another preferred embodiment according to the present invention component (B) bears functional group containing units originating from a compound selected from the group consisting of maleic anhydride, acrylic acid, methacrylic acid, crotonic acid, fumaric acid, fumaric acid anhydride, maleic acid, citraconic acid and mixtures thereof, preferably originating from maleic anhydride.

According to a further preferred embodiment of the present invention component (B) is obtained by copolymerising and/or grafting a copolymer of ethylene with a compound selected from the group consisting of maleic anhydride, acrylic acid, methacrylic acid, crotonic acid and mixtures thereof, whereby grafting with maleic anhydride is preferred.

Grafting can be carried out by any process known in the art such as grafting in a melt without a solvent or in solution or dispersion or in a fluidised bed. Typically, grafting is performed in a heated extruder or mixer as e.g. described in US 3236917 A, US 4639495 A, US 4950541 A or US 5194509 A. Typically, grafting is carried out in a twin-screw extruder such as described in US 4950541 A. Grafting may be carried out in the presence or absence of a radical initiator but is preferably carried out in the presence of a radical initiator such as an organic peroxide, organic perester or organic hydroperoxide.

Still another preferred embodiment in accordance with the present invention stipulates that the content of the functional group containing units originating from unsaturated carboxylic acids or carboxyl acid anhydrides in component (B) is in the range of 0.01 to 2.0 wt.-%, preferably in the range of 0.02 to 1.5 wt.-% and more preferably in the range of 0.20 to 1.0 wt.-%.

Another preferred embodiment stipulates that component (B) is a copolymer of ethylene and 1-octene grafted with maleic anhydride, preferably the content of 1-octene is in the range of 20 to 45 wt.-%, preferably in the range of 22 to 42 wt.-% and more preferably in the range of 25 to 40 wt.-% and still more preferably in the range of 28 to 32 wt.-% based on the overall weight of the copolymer of ethylene and 1-octene and the content of maleic anhydride is in the range of 0.01 to 2.0 wt.-%, preferably in the range of 0.02 to 1.5 wt.-% and more preferably in the range of 0.20 to 1.0 wt.-% based on the overall weight of component (B).

According to another preferred embodiment in accordance with the present invention the melting points of component (B) is in the range of 30°C to below 100°C, preferably in the range of 30°C to below 90°C, more preferably in a range of 30°C to below 80°C and most preferably in a range of 30°C to below 70°C. According to another preferred embodiment in accordance with the present invention the dispersity Mw/Mn of component (B) is most often below 4, such as 3.8 or below, but is at least 1.7. It is preferably between 3.5 and 1.8.

Suitable base copolymers, these means before introducing the functional groups, for component (B) are commercial available, i.a. from Borealis AG under the tradename Queo, from DOW under the tradename Engage or Affinity, or from Mitsui under the tradename Tafmer.

Alternately these base copolymers can be prepared by known processes, in a one stage or two stage polymerization process, comprising solution polymerization, slurry polymerization, gas phase polymerization or combinations therefrom, in the presence of suitable catalysts, like vanadium oxide catalysts or single-site catalysts, e.g. metallocene or constrained geometry catalysts, known to the art skilled persons. A suitable process is inter alia described in WO 2019/201934 A1.

A known solution technology suitable for the process according to the invention is the BORCEED (former COMPACT) technology.

In a further preferred embodiment in accordance with the present invention the content of component (B) in polymer composition (I) is in the range of 0.5 to 5.0 wt.%, preferably in the range of 1.0 to 3.0 wt.-% and more preferably from 1.0 to 2.0 wt.-% based on the overall weight of the polymer composition (I).

Additives

According to a further preferred embodiment in accordance with the present invention polymer composition (I) comprises at least one additive (C) selected from the group consisting of antioxidants, UV light stabilizers, metal deactivators, nucleating agents, clarifiers, optical brighteners, acid scavengers, slip agents, pigments, fillers and flame retardants, tackifiers, plasticisers, crosslinking agents, crosslinking boosters, wavelength-shifting agents and mixtures thereof.

Still another preferred embodiment in accordance with the present invention stipulates that the content of said additive (C) based on the overall weight of the polymer composition (I) is in the range of 0.0001 to 10 wt.-%, preferably in the range from present of 0.01 to 5.0 wt.-% and more preferably in the range of 0.1 to 2.5 wt.-%.

The additives may be added in form of a Masterbatch, the ranges for the content specified above relate to the pure additive.

Polymer composition (I)

The polymer composition (I) in accordance with the present invention mandatorily comprises components (A) and (B).

According to a preferred embodiment of the present invention the content of component (A) in polymer composition (I) is in the range of 95.0 to 99.5 wt.%, preferably in the range of 97.0 to 99.0 wt.-% and more preferably from 98.0 to 99.0 wt.-% based on the overall weight of the polymer composition (I).

In a further preferred embodiment of the present invention the content of component (B) in polymer composition (I) is in the range of 0.5 to 5.0 wt.%, preferably in the range of 1.0 to 3.0 wt.-% and more preferably from 1.0 to 2.0 wt.-% based on the overall weight of the polymer composition (I).

Another preferred embodiment according to the present invention the polymer composition (I) is not crosslinked in the presence of a peroxide or a silanol condensation catalyst selected from carboxylates of tin, zinc, iron, lead or cobalt or aromatic organic sulphonic acids.

Still another preferred embodiment of the present invention stipulates the polymer composition (I) comprises the following components: (A) 97 to 99 wt.-% of a terpolymer of ethylene (a2) with methyl acrylate comonomer units and vinyl trimethoxysilane comonomer units; and (B) 1 to 3 wt.-% of a copolymer of ethylene and 1-octene grafted with maleic acid anhydride having a density in the range of 860 to 880 kg/m$^3$ measured according to ISO 1183 and a $MFR_2$ in the range of 0.5 to 3 g/10 min measured according to ISO 1133 at 190°C and a load of 2.16 kg.

According to a further preferred embodiment the polymer composition (I) comprises and preferably consists of components (A) and (B) and optionally additives (C).

Photovoltaic module

As known in the art, the elements and the layer structure of the photovoltaic module of the invention can vary depending on the desired type of the module. The photovoltaic module can be flexible or rigid. In a preferred embodiment the photovoltaic module is a rigid photovoltaic module.

According to a preferred embodiment in accordance with the present invention the photovoltaic module comprises a front encapsulant layer element and rear encapsulant layer element, whereby at least one of these encapsulant layer elements and preferably both encapsulant layer elements comprise polymer composition (I) and more preferably consist of polymer composition (I).

In a further preferred embodiment of the present invention the protective front layer element is a rigid protective front layer element, preferably a front glass layer element and/or the protective back layer element is a rigid protective back layer element, preferably a back glass layer element.

Depending on the nature of the protective back element, the protective back element can optionally be covered by a protective cover, like a metal frame, such as an aluminium frame, which can further comprise a junction box being often mounted on the back glass layer of the element. Such a protective cover is typically only present, when the protective back element is a backsheet layer element or for glass-glass modules.

According to another preferred embodiment in accordance with the present invention the protective back layer element is a polymeric backsheet. The polymeric material is preferably selected from the group consisting of polyethylenterephthalate, polyvinylidenefluoride, polyvinylfluoride and polypropylene.

Still another preferred embodiment in accordance with the present invention stipulates that the retained $P_{max}$ determined according to IEC 60904 of the photovoltaic module is above 95 %, preferably in the range of 95 to 100 % and more preferably in the range of 97 to 99.5 %.

The thickness of the different layer elements of photovoltaic module can vary depending on the type of the photovoltaic module and the material of the layer elements.

As a non-limiting example only, the front and/or back encapsulation layer element, independently typically have a thickness of up to 2.0 mm, preferably up to 1.0 mm, typically from 0.3 mm to 2.0 mm. In certain embodiments thin encapsulation layer elements are used which have a thickness of 0.2 mm to 0.5 mm. In other embodiments thicker encapsulation layer elements are used which have a thickness of more than 0.5 mm to 2.0 mm, preferably from 0.6 to 1.0 mm.

As a non-limiting example only, the thickness of the protective front layer element, e.g. glass layer, is typically up to 10 mm, preferably up to 8 mm, preferably 2 to 4 mm.

As a non-limiting example only, the thickness of the protective back element, e.g. glass layer, is typically up to 10 mm, preferably up to 8 mm, preferably 2 to 4 mm.

As a non-limiting example only, the thickness of a photovoltaic cell element, e.g. an element of monocrystalline photovoltaic cell(s), is typically between 100 to 500 microns.

It is also to be understood that part of the elements can be in integrated form, i.e. two or more of said photovoltaic elements can be integrated together, preferably by lamination, before the integrated elements are assembled for the production of the photovoltaic module.

The photovoltaic module of the invention can be produced in a manner well known in the field of the photovoltaic modules. The polymeric layer elements can be produced for example by extrusion, preferably by co- or cast film extrusion, in a conventional manner using the conventional extruder and film formation equipment. The layers of any multilayer element(s) and/or any adjacent layer(s) between two layer elements can be partly or fully coextruded or laminated.

The different elements of the photovoltaic module are typically assembled together by conventional means to produce the final photovoltaic module. Elements can be provided to such assembly step separately or e.g. two elements can fully or partly be in integrated form, as well known in the art. The different element parts can then be attached together by lamination using the conventional lamination techniques in the field. The assembling of photovoltaic module is well known in the field of photovoltaic modules.

Said front and/or rear encapsulation monolayer element is/are preferably extruded or laminated, preferably laminated, to adjacent layer elements or coextruded with a layer(s) of an adjacent layer element.

Use

The present invention further relates to the use of an encapsulation layer element comprising polymer composition (I) as specified above for retaining the $P_{max}$ determined after 96 h according to IEC 60904, by applying the foil method with a temperature of 85°C and relative humidity of 60 % and a potential difference of 1500 V, of a photovoltaic module comprising besides the encapsulation layer element a protective front layer element, a photovoltaic cell element and a protective back element, whereby at least one of the protective elements comprises glass.

All preferred aspects and embodiments as described above shall also hold for the use.

The invention will now be described with reference to the following non-limiting examples.

**Experimental Part**

**A. Measuring methods**

The following definitions of terms and determination methods apply for the above general description of the invention as well as to the below examples unless otherwise defined.

**Melt Flow Rate**

The melt flow rate (MFR) was determined according to ISO 1133 - Determination of the melt mass-flow rate (MFR) and melt volume-flow rate (MVR) of thermoplastics -- Part 1: Standard method and is indicated in g/10 min. The MFR is an indication of the flowability, and hence the processability, of the polymer. The higher the melt flow rate, the lower the viscosity of the polymer. The $MFR_2$ of polyethylene is determined at a temperature of 190°C and a load of 2.16 kg.

**Density**

Low density polyethylene (LDPE):

The density of the polymer was measured according to ISO 1183-2. The sample preparation was executed according to ISO 1872-2 Table 3 Q (compression moulding).

**Comonomer contents**

**The content (wt.-% and mol-%) of polar comonomer present in the polymer and the content (wt.-% and mol.-%) of silane group(s) containing units (preferably comonomer) present in the polymer composition (preferably in the polymer)**

Quantitative nuclear-magnetic resonance (NMR) spectroscopy was used to quantify the comonomer content of the polymer composition or polymer as given above or below in the context.

Quantitative $^1$H NMR spectra recorded in the solution-state using a Bruker Advance III 400 NMR spectrometer operating at 400.15 MHz. All spectra were recorded using a standard broad-band inverse 5 mm probehead at 100°C using nitrogen gas for all pneumatics.

Approximately 200 mg of material was dissolved in *1,2*-tetrachloroethane-$d_2$ (TCE-$d_2$) using ditertiarybutylhy-droxytoluen (BHT) (CAS 128-37-0) as stabiliser. Standard single-pulse excitation was employed utilising a 30 degree pulse, a relaxation delay of 3 s and no sample rotation. A total of 16 transients were acquired per spectra using 2 dummy scans. A total of 32k data points were collected per FID with a dwell time of 60 μs, which corresponded to a spectral window of approx. 20 ppm. The FID was then zero filled to 64k data points and an exponential window function applied with 0.3 Hz line-broadening. This setup was chosen primarily for the ability to resolve the quantitative signals resulting from methylacrylate and vinyltrimethylsiloxane copolymerisation when present in the same polymer.

Quantitative $^1$H NMR spectra were processed, integrated and quantitative properties determined using custom spectral analysis automation programs. All chemical shifts were internally referenced to the residual protonated solvent signal at 5.95 ppm.

When present characteristic signals resulting from the incorporation of vinylacytate (VA), methyl acrylate (MA), butyl acrylate (BA) and vinyltrimethylsiloxane (VTMS), in various comonomer sequences, were observed (Randell89). All comonomer contents calculated with respect to all other monomers present in the polymer.

The vinylacytate (VA) incorporation was quantified using the integral of the signal at 4.84 ppm assigned to the *VA sites, accounting for the number of reporting nuclie per comonomer and correcting for the overlap of the OH protons from BHT when present:

$$VA = (\ I_{*VA} - (I_{ArBHT})/2)\ /\ 1$$

The methylacrylate (MA) incorporation was quantified using the integral of the signal at 3.65 ppm assigned to the 1MA sites, accounting for the number of reporting nuclie per comonomer:

$$MA = I_{1MA}\ /\ 3$$

The butylacrylate (BA) incorporation was quantified using the integral of the signal at 4.08 ppm assigned to the 4BA sites, accounting for the number of reporting nuclie per comonomer:

$$BA = I_{4BA}\ /\ 2$$

The vinyltrimethylsiloxane incorporation was quantified using the integral of the signal at 3.56 ppm assigned to the 1VTMS sites, accounting for the number of reporting nuclei per comonomer:

$$VTMS = I_{1VTMS}\ /\ 9$$

Characteristic signals resulting from the additional use of BHT as stabiliser, were observed. The BHT content was quantified using the integral of the signal at 6.93 ppm assigned to the ArBHT sites, accounting for the number of reporting nuclei per molecule:

$$BHT = I_{ArBHT} / 2$$

The ethylene comonomer content was quantified using the integral of the bulk aliphatic (bulk) signal between 0.00 - 3.00 ppm. This integral may include the 1VA (3) and $\alpha$VA (2) sites from isolated vinylacetate incorporation, *MA and $\alpha$MA sites from isolated methylacrylate incorporation, 1BA (3), 2BA (2), 3BA (2), *BA (1) and $\alpha$BA (2) sites from isolated butylacrylate incorporation, the *VTMS and $\alpha$VTMS sites from isolated vinylsilane incorporation and the aliphatic sites from BHT as well as the sites from polyethylene sequences. The total ethylene comonomer content was calculated based on the bulk integral and compensating for the observed comonomer sequences and BHT:

$$E = (1/4)*[ I_{bulk} - 5*VA - 3*MA - 10*BA - 3*VTMS - 21*BHT ]$$

It should be noted that half of the $\alpha$ signals in the bulk signal represent ethylene and not comonomer and that an insignificant error is introduced due to the inability to compensate for the two saturated chain ends (S) without associated branch sites.

The total mole fractions of a given monomer (M) in the polymer was calculated as:

$$fM = M / ( E + VA + MA + BA + VTMS )$$

The total comonomer incorporation of a given monomer (M) in mole percent was calculated from the mole fractions in the standard manner:

$$M [mol\%] = 100 * fM$$

The total comonomer incorporation of a given monomer (M) in weight percent was calculated from the mole fractions and molecular weight of the monomer (MW) in the standard manner:

$$M [wt.\text{-}\%] = 100 * ( fM * MW) / ( (fVA * 86.09) + (fMA * 86.09) + (fBA * 128.17) + (fVTMS * 148.23) + ((1\text{-}fVA\text{-}fMA\text{-}fBA\text{-}fVTMS) * 28.05) )$$

randall89: J. Randall, Macromol. Sci., Rev. Macromol. Chem. Phys. 1989, C29, 201.

If characteristic signals from other specific chemical species are observed the logic of quantification and/or compensation can be extended in a similar manner to that used for the specifically described chemical species. That is, identification of characteristic signals, quantification by integration of a specific signal or signals, scaling for the number of reported nuclei and compensation in the bulk integral and related calculations. Although this process is specific to the specific chemical species in question the approach is based on the basic principles of quantitative NMR spectroscopy of polymers and thus can be implemented by a person skilled in the art as needed.

**Melting temperature (Tm), crystallization temperature ($T_c$), heat of fusion ($\Delta H_{fusion}$), crystallization enthalpy ($\Delta H_{cryst}$) and degree of crystallinity**

$Tm$, $T_c$, $\Delta H_{fusion}$ and $\Delta H_{cryst}$ were measured with a TA Instrument Q200 differential scanning calorimetry (DSC) on 5 to 7 mg samples. DSC is run according to ISO 11357 / part 3 /method C2 in a heat / cool / heat cycle with a scan rate of 10 °C/min in the temperature range of -30 to +225°C. Crystallization temperature ($T_c$) and crystallization enthalpy ($H_{cryst}$) are determined from the cooling step, while melting temperature ($T_m$) and heat of fusion ($H_{fusion}$) are determined from the second heating step. The crystallinity is calculated from the heat of fusion by assuming an $H_{fusion}$-value of 209 J/g for a fully crystalline polypropylene (see Brandrup, J., Immergut, E. H., Eds. Polymer Handbook, 3rd ed. Wiley, New York, 1989; Chapter 3).

**Dynamic Shear Measurements (frequency sweep measurements)**

The characterisation of melt of polymer composition or polymer as given above or below in the context by dynamic shear measurements complies with ISO standards 6721-1 and 6721-10. The measurements were performed on an Anton Paar MCR501 stress controlled rotational rheometer, equipped with a 25 mm parallel plate geometry. Measurements were undertaken on compression moulded plates, using nitrogen atmosphere and setting a strain within the linear viscoelastic regime. The oscillatory shear tests were done at 190 °C applying a frequency range between 0.01 and 600 rad/s and setting a gap of 1.3 mm.

In a dynamic shear experiment the probe is subjected to a homogeneous deformation at a sinusoidal varying shear strain or shear stress (strain and stress controlled mode, respectively). On a controlled strain experiment, the probe is subjected to a sinusoidal strain that can be expressed by

$$\gamma(t) = \gamma_0 \sin(\omega t) \tag{1}$$

If the applied strain is within the linear viscoelastic regime, the resulting sinusoidal stress response can be given by

$$\sigma(t) = \sigma_0 \sin(\omega t + \delta) \tag{2}$$

where

$\sigma_0$ and $\gamma_0$ are the stress and strain amplitudes, respectively
$\omega$ is the angular frequency
$\delta$ is the phase shift (loss angle between applied strain and stress response)
t is the time.

Dynamic test results are typically expressed by means of several different rheological functions, namely the shear storage modulus G', the shear loss modulus, G", the complex shear modulus, G*, the complex shear viscosity, $\eta$*, the dynamic shear viscosity, $\eta$', the out-of-phase component of the complex shear viscosity $\eta$" and the loss tangent, tan $\delta$ which can be expressed as follows:

$$G' = \frac{\sigma_0}{\gamma_0} \cos\delta \ [\text{Pa}] \tag{3}$$

$$G'' = \frac{\sigma_0}{\gamma_0} \sin\delta \ [\text{Pa}] \tag{4}$$

$$G^* = G' + iG'' \ [\text{Pa}] \tag{5}$$

$$\eta^* = \eta' - i\eta'' \ [\text{Pa.s}] \tag{6}$$

$$\eta' = \frac{G''}{\omega} \ [\text{Pa.s}] \tag{7}$$

$$\eta'' = \frac{G'}{\omega} \ [\text{Pa.s}] \tag{8}$$

Besides the above-mentioned rheological functions one can also determine other rheological parameters such as the so-called elasticity index *EI(x)*. The elasticity index *EI(x)* is the value of the storage modulus, G' determined for a value of the loss modulus, G" of x kPa and can be described by equation (9).

$$EI(x) = G' \; for \; (G'' = x \; kPa) \; [Pa] \qquad\qquad (9)$$

For example, the EI(5kPa) is the defined by the value of the storage modulus G', determined for a value of G" equal to 5 kPa.

Shear Thinning Index ($SHI_{0.05/300}$) is defined as a ratio of two viscosities measured at frequencies 0.05 rad/s and 300 rad/s, $\mu_{0.05}/\mu_{300}$.

References:

[1] Rheological characterization of polyethylene fractions" Heino, E.L., Lehtinen, A., Tanner J., Seppälä, J., Neste Oy, Porvoo, Finland, Theor. Appl. Rheol., Proc. Int. Congr. Rheol., 11th (1992), 1, 360-362.
[2] The influence of molecular structure on some rheological properties of polyethylene", Heino, E.L., Borealis Polymers Oy, Porvoo, Finland, Annual Transactions of the Nordic Rheology Society, 1995.
[3] Definition of terms relating to the non-ultimate mechanical properties of polymers, Pure & Appl. Chem., Vol. 70, No. 3, pp. 701-754, 1998.

**FTIR**

FTIR was used for determining the content of grafting agent in Polymer B

Sample preparation

A small amount of sample (pellets) was compression pressed (*) into films/plaques (thickness 0.5 mm) with aid of a compression mould und the conditions below.
(*) pressing/moulding:
4 min at 180°C ("free melting", no pressure exerted)
2 min at 180°C under pressure (~45 kN)
2 min cooling under pressure

FTIR, calculations:

IR spectra from the films/plaques were measured on a Bruker Tensor 27. Peaks intensities (relative to the baseline) are recorded; component peak (related to maleic anhydride) at between ~ 1782-1797 cm-1 (baseline 1847 cm -1) and reference peak at ~ 2641-2707 cm -1 (baseline 2450 cm-1).
The value from component/reference was calculated and compared to the calibration curve, which resulted in the total maleic anhydride-content in the polymer. The maleic anhydride content in the calibration standards have been determined with the titration method described below.

**Sample preparation for titration method**

The sample was mixed thoroughly. The sample was in the form of pellets.

Blind - test

When heating xylene and dissolving the sample, close the container loosely with a ground glass stopper to allow the pressures to equalize and prevent the solution from splashing out of the bottle. For example, a piece of paper or a thin iron wire can be inserted between the neck of the bottle and the grinding cap to prevent the cap from sticking.
To 50 ml of xylene with a touch of antioxidant few drops of phenolphthalein indicator was added. Then the resulting solution was heated (> 100 ° C) with a magnetic stirrer and titrated hot with 0.02 N KOH / IPA solution. Colour change is noted: colourless => red (clear) The titration takes up the indicator, titration is continued until the colour remains stable for about 10 seconds. The consumption is recorded.

Procedure for the sample

Approximately 600 to 800 mg of sample pellets were weighed into an Erlenmeyer flask, then 50 ml of xylene with a touch of antioxidant (prevents oxidation of the product during machining) and magnetic stir bar added into the flask. As next the flask was stoppered and transferred to a heated magnetic stirrer located in the fume cupboard. Allowed the sample to dissolve. It took about 15 minutes for the sample to dissolve. Then few drops of phenolphthalein indicator were added. Sample was titrated hot (> 100 ° C) with 0.02 N KOH / IPA solution. The consumption is recorded. Color change is noted: colorless => red (clear).

Calculation

$$\text{Total acid content (w\%)} = (((Vn-Vs) \times N \times E \text{ (acid)}) /W) \times 100$$

where:

N = normalization of the titration solution, mekv / ml
W = sample weight in g
Vn = sample consumption, ml
Vs = blind consumption, ml
E = equivalent acid weight in g / mekv
E = (maleic acid) = 0.116 / 2 = 0.058
E = (maleic anhydride) = 0.098

The result was expressed to two decimal places (X, xx) as a percentage by weight.

**B. Materials used**

**Preparation of Polymer 1:**

**Copolymer of ethylene with methyl acrylate comonomer and with vinyl trimethoxysilane comonomer**

The copolymer of ethylene with methyl acrylate comonomer and vinyl trimethoxysilane comonomer (polymer 1) was produced in a commercial high pressure tubular reactor at a pressure 2500-3000 bar and max temperature 250-300 °C using conventional peroxide initiatior. Ethylene monomer, methyl acrylate (MA) polar comonomer and vinyl trimethoxy silane (VTMS) comonomer were added to the reactor system in a conventional manner. Chain transfer agent was used to regulate melt flow rate as well known for a skilled person. After having the information of the property balance desired for the final polymer 1, the skilled person can control the process to obtain polymer 1.
The amount of the vinyl trimethoxy silane units, VTMS, the amount of methyl acrylate, MA, and $MFR_2$ are given in the Table 1.

The properties in Table 1 were measured from the polymer 1 as obtained from the reactor.

**Table 1:** Product properties of Polymer 1.

| Properties of the polymer obtained from the reactor | Polymer 1 |
|---|---|
| $MFR_{2,16}$, g/10 min | 4.5 |
| Methyl acrylate content, mol% (wt%) | 8.6 (22) |
| Melt Temperature, °C | 90 |
| VTMS content, mol% (wt%) | 0.38 (1.7) |
| Density, kg/m$^3$ | 946 |
| SHI (0.05/300), 150°C | 52 |

In above Table 1 and below MA denotes the content of Methyl Acrylate comonomer present in the polymer and, respectively, VTMS content denotes the content of vinyl trimethoxy silane comonomer present in the polymer.

**Polymer A (Copolymer of ethylene with 1-octene)**

Queo™ 7007LA is an ethylene based 1-octene elastomer produced in a solution polymerization process using a metallocene catalyst with a $MFR_2$ (2.16 kg, 190°C) of 6.6 g/10 min and a density of 870 $kg/m^3$ and is commercially available from Borealis AG, Austria.

**Preparation of Polymer B (polymer A grafted with maleic anhydride)**

The extruder used for the MAH-grafting was a Werner & Pfleiderer ZSK 30 co-rotating extruder with L/D of 38 with 12 barrels. The temperature control of the extruder barrels was divided into 6 control sections. Barrel 1 was the feeding section. Barrels 2&3, 5&6, 7&8, 9&10 15 and 11&12 share the same control loop in pairs and only took measurement from one barrel per pair. Barrel 4 was the only one with its own control loop. The barrels were heated with electrical heaters and cooled with closed loop water-glycol circulation if necessary, or were not cooled (in normal operation typically no cooling is necessary). In addition to the temperature measurements from the barrels, the melt temperature and pressure at the die 20 plate were also measured. The following temperatures of the different zones of the extruder as listed below were targeted for the examples:

    Temperature Feeding zone [°C] <40
    Temperature Control zone 1 [°C] 180
    Temperature Control zone 2 [°C] 200
    Temperature Control zone 3 [°C] 200
    Temperature Control zone 4 [°C] 200
    Temperature Control zone 5 [°C] 200
    Temperature Control zone 6 [°C] 200
    Temperature die plate [°C] 200

Queo 7007LA was grafted by adding various amounts of maleic anhydride (MAH). The peroxide initiator (0.1 wt.-% POX - Perkadox 14S-fl, Akzo Nobel) was fed as a 10% isododecane solution.

A dry blend of Queo 7007LA and MAH was fed through the hopper into the feeding section of the extruder. The POX solution was fed into a side feeding entrance into the feeding section of the extruder. The screw speed was 200 rpm and the throughput was 8 kg/h.

The residence time was 60 seconds. This resulted in a content of grafted maleic anhydride grafting of 0.22 wt.-%, as determined by FTIR.

**C. Manufacturing of PV modules and testing**

**Preparation of the polymer compositions for the encapsulation layers of photovoltaic modules 1 to 6**

For the encapsulation layers of photovoltaic modules 1 and 2 only polymer 1 was used.

For the encapsulation layers of photovoltaic modules 3 and 4, 90 wt.-% of Polymer 1 and 10 wt.-% of polymer A was premixed prior to film extrusion.

For the encapsulation layers of photovoltaic modules 5 and 6, 88.5 wt.-% of Polymer 1 and 1.5 wt.-% of polymer B was premixed prior to film extrusion.

**Preparation of the encapsulation layer element**

The encapsulation layer elements of the inventive and comparative examples, with dimensions of 995 mm width and 0.45 mm thickness were prepared in a Breyer CellProtect film line, using a melt temperature of 150°C and at lines speeds of 20 mpm (meter per minute).

**Preparation of the photovoltaic modules**

**PV module elements:**

Protective front layer element: Glass layer, structured solar glass, soda-lime, low iron glass, supplied by Hemelaers Glas, length: 200 mm and width: 200 mm, total thickness of 3.2 mm.

Front and rear encapsulant element: films of the polymer compositions as described above, with same width and length dimensions as the protective front and back layer element, each had the total thickness of 0.45 mm.

PV cell element: 1 soldered bifacial solar cell, cell dimension 156*156 mm from LightWay Solar, pseudosquare, 5 busbars, total thickness of 200 micron.

Protective back layer element: Glass layer, structured solar glass, soda-lime, low iron glass, supplied by Hemelaers Glas, length: 200 mm and width: 200 mm, total thickness of 3.2 mm.

**Preparation of PV module (1-cell solar module) assembly for the lamination**

Two PV module assemblies were prepared for each encapsulation layer element as follows. The front protective glass element was cleaned with isopropanol before putting the first encapsulation layer element film on the solar glass. The solar glass element has the following dimensions: 200 mm x 200 mm x 3,2 mm (b*l*d). The front encapsulation layer element was cut in the same dimension as the solar glass element. After the front encapsulation layer element was put on the front protective glass element, then the soldered solar cell was put on the front encapsulation layer element. Further the rear encapsulation layer element was put on the obtained PV cell element and the back protective glass element was cleaned with isopropanol before it was put on said rear encapsulation layer element. The obtained PV module assembly was then subjected to a lamination process as described below.

**Lamination process of the solar modules:**

**Laminator:** Incapcell 18-11, supplied by SM InnoTech GmbH.
Each PV module assembly sample was laminated in an Incapcell 18-11 laminator from SM InnoTech GmbH with a laminator temperature setting and pressure setting adapted to the encapsulation layer elements. The lamination settings are given in Table 2.

**Table 2:** Lamination settings for photovoltaic modules 1 to 6.

|  | Module 1 | Module 2 | Module 3 | Module 4 | Module 5 | Module 6 |
|---|---|---|---|---|---|---|
| Encapsulation layer elements | Polymer 1 | Polymer 1 | Polymers 1 & A | Polymers 1 & A | Polymers 1 & B | Polymers 1 & B |
| Temperature, °C | 165 | 165 | 165 | 165 | 165 | 165 |
| Pressure, mbar | 700 | 700 | 700 | 700 | 700 | 700 |
| Total time of steps, s | 1380 | 1380 | 1380 | 1380 | 1380 | 1380 |

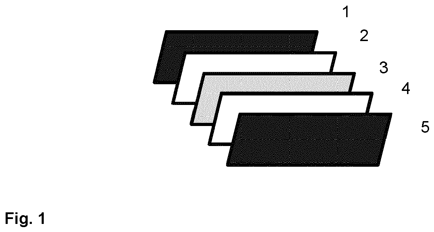

A 1-cell photovoltaic module prepared according to the lamination process as described above is shown in Figure 1 illustrating the layer elements (separated) of the photovoltaic module, namely a protective front layer element (1), a front encapsulation layer element (2), a photovoltaic cell element (3), a rear encapsulation layer element (4) and a protective back layer element (5).

**PID Testing**

The 1-cell PV modules underwent PID stress testing according to the foil method as described in IEC62804-1: "Test methods for detection of potential-induced degradation of crystalline silicon photovoltaic (PV) modules". The foil method was applied, with a temperature of 85°C and relative humidity of 60% being the (controlled, stable) environmental stress conditions throughout the test duration, using a Vötsch climate chamber. A 1500 V potential difference was applied between the aluminium (Al) foils and the short-circuited solar cell. During PID stress, the solar cell was at a negative potential (-1500 V) with respect to the Al foils (0 V). Hence, driving positive charges towards the solar cell. The 1-cell modules laminates were put under bifacial PID stress, i.e. Al foils at high voltage difference to the solar cell attached to both the front and the rear SLG covers. The test duration for the PID-test was 96h.

**Flash test**

The PV power loss under PID stress was quantified using a pv-tools LOANA PV analysis system for all 1-cell modules. All characterization measurements were conducted from both the front side and the rear side of the single-cell laminates using monofacial illumination and a black cloth underneath the laminate to reduce the reflected irradiance.

The power output loss was calculated as the relative difference in $P_{max}$ before and after the 96h PID test. All IV-characterisation was done in accordance with the IEC 60904 standard.

**Table 3:** Retained power $P_{max}$ for modules 1 to 6.

| | Module 1 (CE1a) | Module 2 (CE1b) | Module 3 (CE2a) | Module 4 (CE2b) | Module 5 (IE1a) | Module 6 (IE1b) |
|---|---|---|---|---|---|---|
| Encapsulation layer elements | 100 wt.-% polymer 1 | 100 wt.-% polymer 1 | 90 wt.-% polymer 1 10 wt.-% Polymer A | 90 wt.-% polymer 1 10 wt.-% Polymer A | 98.5 wt.-% polymer 1 1.5 wt.-% polymer B | 98.5 wt.-% polymer 1 1.5 wt.-% polymer B |
| Retained $P_{max}$ 96 h (front side) [%][a] | 91.5 | 94.4 | 74.5 | 80.9 | 97.5 | 98.2 |
| Retained $P_{max}$ 96 h (back side) [%][a] | 78.5 | 80.4 | 20.9 | 32.3 | 91.7 | 93.4 |
| a): average of 3 measurements | | | | | | |

**D. Discussion of the results**

From Table 3, it can be concluded that the photovoltaic modules including a front and rear encapsulation layer element comprising polymers 1 and B show only minor losses of $P_{max}$ after the PID test (IE1a and IE1b).

Surprisingly, the addition of polymer A to polymer 1 accelerates the PID of the modules, as is seen by the lower retained power for CE2a and CE2b, whereas the addition of polymer B - being the same base polymer, but grafted with maleic anhydride - to polymer 1 reduces the power drop compared to the modules having an encapsulant consisting solely of polymer 1 (see the comparison CE1a and CE1b with IE1a and IE1b). Further, the conclusion is valid both for the power retention on the front and the rear side of the bifacial module.

**Claims**

1. A photovoltaic module comprising a protective front layer element, an encapsulation layer element, a photovoltaic cell element and a protective back layer element, whereby at least one of the protective elements comprises glass; wherein the encapsulation layer element comprises a polymer composition (I) comprising at least the following components:

   (A) 90 to 99.8 wt.-% based on the overall weight of the polymer composition (I) of a polymer selected from a polyolefin elastomer or a polymer of ethylene (a) selected from

   (a1) a copolymer of ethylene which bears functional groups containing units;
   (a2) a copolymer of ethylene comprising one or more polar comonomer unit(s) selected from (C1-C6)-alkyl acrylate or (C1-C6)-alkyl (C1-C6)-alkyl acrylate comonomer units, and optionally bears functional groups containing units different from said polar comonomer unit(s);
   (a3) a copolymer of ethylene comprising one or more alpha-olefin comonomer unit(s); and optionally bears functional groups containing units different from said polar comonomer unit(s) of polymer (a2);
   or mixtures thereof; and
   (b) silane group(s) containing units;

   (B) 0.2 to 10 wt.-% based on the overall weight of the polymer composition (I) of a copolymer of ethylene, which bears functional group containing units originating from at least one unsaturated carboxylic acid and/or its anhydrides, metal salts, esters, amides or imides and mixtures thereof, whereby component (B) is different from component (A);

   whereby components (A) and (B) add up to 100 wt.-%.

2. The photovoltaic module according to claim 1, **characterized in that**,
component (A) comprises and preferably consists of

(a1) a copolymer of ethylene which bears silane group(s) containing units (b) as functional groups containing units; or
(a2) a copolymer of ethylene comprising one or more polar comonomer unit(s) selected from (C1-C6)-alkyl acrylate or (C1-C6)-alkyl (C1-C6)-alkyl acrylate comonomer units, and optionally bears silane group(s) containing units (b) as functional groups containing units different from said polar comonomer unit(s);

preferably component (A) is

(a1) a copolymer of ethylene which bears silane group(s) containing units (b) as functional groups containing units; or
(a2) a polymer of ethylene comprising methyl acrylate comonomer units and bears silane group(s) containing units (b) as functional groups containing units different from said polar comonomer unit(s); and

more preferably component (A) is a copolymer of ethylene (a1) with vinyl trimethoxysilane comonomer units or a terpolymer of ethylene (a2) with methyl acrylate comonomer units and vinyl trimethoxysilane comonomer units.

3. The photovoltaic module according to claim 1 or 2, **characterized in that**,
component (A) is different from a polyolefin elastomer.

4. The photovoltaic module according to any one of the preceding claims, **characterized in that**,
component (B) is a copolymer of ethylene and a $C_4$ to $C_{10}$ alpha olefin comonomer, preferably a copolymer of ethylene and 1-octene; whereby said copolymer before introducing the functional group has

(i) a density in the range of 850 kg/m$^3$ to 920 kg/m$^3$, preferably in the range of 860 to 905 kg/m$^3$ and more preferably in the range of 865 to 900 kg/m$^3$ measured according to ISO 1183; and/or
(ii) an MFR$_2$ in the range of 0.1 to 20.0 g/10 min, preferably in the range of 0.5 to 10 g/10 min and more preferably in the range of 0.5 to 3 g/10 min measured according to ISO 1133 at 190°C and a load of 2.16 kg.

5. The photovoltaic module according to any one of claims 1 to 4, **characterized in that**,
the copolymer of ethylene for component (B) is a copolymer of ethylene and methyl acrylate or a copolymer of ethylene and butyl acrylate.

6. The photovoltaic module according to any one of the preceding claims, **characterized in that**,
component (B) bears functional group containing units originating from a compound selected from the group consisting of maleic anhydride, acrylic acid, methacrylic acid, crotonic acid, fumaric acid, fumaric acid anhydride, maleic acid, citraconic acid and mixtures thereof, preferably originating from maleic anhydride; and/or
component (B) is obtained by copolymerising and/or grafting a copolymer of ethylene with a compound selected from the group consisting of maleic anhydride, acrylic acid, methacrylic acid, crotonic acid and mixtures thereof, whereby grafting with maleic anhydride is preferred.

7. The photovoltaic module according to any one of the preceding claims, **characterized in that**,
the content of the functional group containing units originating from unsaturated carboxylic acids or carboxyl acid anhydrides in component B) is in the range of 0.01 to 2.0 wt.-%, preferably in the range of 0.02 to 1.5 wt.-% and more preferably in the range of 0.20 to 1.0 wt.-%.

8. The photovoltaic module according to any one of the preceding claims, **characterized in that**,
polymer composition (I) comprises at least one additive (C) selected from the group consisting of antioxidants, UV light stabilizers, metal deactivators, nucleating agents, clarifiers, optical brighteners, acid scavengers, slip agents, pigments, fillers and flame retardants, tackifiers, plasticisers, crosslinking agents, crosslinking boosters, wavelength-shifting agents and mixtures thereof; preferably the content of said additive (C) based on the overall weight of the polymer composition (I) is in the range of 0.0001 to 10 wt.-%, preferably in the range from present of 0.01 to 5.0 wt.-% and more preferably in the range of 0.1 to 2.5 wt.-%.

9. The photovoltaic module according to any one of the preceding claims, **characterized in that**,
the content of component (A) in polymer composition (I) is in the range of 95.0 to 99.5 wt.%, preferably in the range of 97.0 to 99.0 wt.-% and more preferably from 98.0 to 99.0 wt.-% based on the overall weight of the polymer composition (I); and/or

the content of component (B) in polymer composition (I) is in the range of 0.5 to 5.0 wt.%, preferably in the range of 1.0 to 3.0 wt.-% and more preferably from 1.0 to 2.0 wt.-% based on the overall weight of the polymer composition (I).

10. The photovoltaic module according to any one of the preceding claims, **characterized in that**,
    the photovoltaic module comprises a front encapsulant layer element and rear encapsulant layer element, whereby at least one of these encapsulant layer elements and preferably both encapsulant layer elements comprise polymer composition (I) and more preferably consist of polymer composition (I) and/or
    polymer composition (I) is not cross-linked in the presence of a peroxide or a silanol condensation catalyst selected from carboxylates of tin, zinc, iron, lead or cobalt or aromatic organic sulphonic acids.

11. The photovoltaic module according to any one of the preceding claims, **characterized in that**,
    the protective front layer element is a rigid protective front layer element, preferably a front glass layer element; and/or
    the protective back layer element is a rigid protective back layer element, preferably a back glass layer element.

12. The photovoltaic module according to any one of claims 1 to 10, **characterized in that**
    the protective back layer element is a polymeric backsheet.

13. The photovoltaic module according to any one of the preceding claims, **characterized in that**,
    the retained $P_{max}$ determined according to IEC 60904 of the photovoltaic module is above 95 %, preferably in the range of 95 to 100 % and more preferably in the range of 97 to 99.5 %.

14. The photovoltaic module according to any one of the preceding claims, **characterized in that**,
    polymer composition (I) comprises the following components:

    (A) 97 to 99 wt.-% of a terpolymer of ethylene (a2) with methyl acrylate comonomer units and vinyl trimethoxysilane comonomer units; and
    (B) 1 to 3 wt.-% of a copolymer of ethylene and 1-octene grafted with maleic acid anhydride having a density in the range of 860 to 880 kg/m$^3$ measured according to ISO 1183 and a MFR$_2$ in the range of 0.5 to 3 g/10 min measured according to ISO 1133 at 190°C and a load of 2.16 kg.

15. Use of an encapsulation layer element comprising polymer composition (I) according to any one of claims 1 to 10 or 14 for increasing the $P_{max}$ determined after 96 h according to IEC 60904, by applying the foil method with a temperature of 85°C and relative humidity of 60 % and a potential difference of 1500 V, of a photovoltaic module comprising besides the encapsulation layer element a protective front layer element, a photovoltaic cell element and a protective back element, whereby at least one of the protective elements comprises glass.

Fig. 1

Europäisches
Patentamt

European
Patent Office

Office européen
des brevets

# EUROPEAN SEARCH REPORT

Application Number

EP 20 16 6956

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 913 358 A1 (JNC CORP [JP]; JNC PETROCHEMICAL CORP [JP]) 2 September 2015 (2015-09-02) | 1-6, 8-13,15 | INV. H01L31/048 |
| A | * paragraph [0012] * <br> * paragraph [0014] * <br> * paragraph [0040] * <br> * paragraph [0003] * <br> * paragraph [0088] * <br> * paragraph [0032] * <br> * paragraph [0059] * <br> * paragraph [0067] * <br> * paragraph [0021] - paragraph [0022] * | 7,14 | |
| A,D | WO 2019/173262 A1 (DU PONT) 12 September 2019 (2019-09-12) * page 10, line 20 - page 11, line 4 * | 1-15 | |
| A | EP 3 222 662 A1 (BOREALIS AG [AT]) 27 September 2017 (2017-09-27) * paragraph [0006] - paragraph [0009] * <br> * paragraph [0011] - paragraph [0013] * <br> * paragraph [0023] * <br> * paragraph [0039] * <br> * paragraph [0043] * | 1-15 | |
| A | WO 2018/099816 A1 (BOREALIS AG [AT]) 7 June 2018 (2018-06-07) * page 4, line 28 - page 6, line 6 * <br> * * <br> * * <br> * * | 1-15 | |
| A | EP 2 644 652 A2 (LG CHEMICAL LTD [KR]) 2 October 2013 (2013-10-02) * paragraph [0010] - paragraph [0014] * | 1-15 | |

TECHNICAL FIELDS SEARCHED (IPC)

H01L

The present search report has been drawn up for all claims

| Place of search | Date of completion of the search | Examiner |
|---|---|---|
| Berlin | 3 September 2020 | Chao, Oscar |

EPO FORM 1503 03.82 (P04C01)

**ANNEX TO THE EUROPEAN SEARCH REPORT
ON EUROPEAN PATENT APPLICATION NO.**

EP 20 16 6956

This annex lists the patent family members relating to the patent documents cited in the above-mentioned European search report.
The members are as contained in the European Patent Office EDP file on
The European Patent Office is in no way liable for these particulars which are merely given for the purpose of information.

03-09-2020

| Patent document cited in search report | | Publication date | Patent family member(s) | | Publication date |
|---|---|---|---|---|---|
| EP 2913358 | A1 | 02-09-2015 | CN | 104736626 A | 24-06-2015 |
| | | | EP | 2913358 A1 | 02-09-2015 |
| | | | JP | 6172158 B2 | 02-08-2017 |
| | | | JP | WO2014065251 A1 | 08-09-2016 |
| | | | TW | 201422699 A | 16-06-2014 |
| | | | WO | 2014065251 A1 | 01-05-2014 |
| WO 2019173262 | A1 | 12-09-2019 | NONE | | |
| EP 3222662 | A1 | 27-09-2017 | AU | 2017236139 A1 | 23-08-2018 |
| | | | CA | 3014491 A1 | 28-09-2017 |
| | | | CN | 108779304 A | 09-11-2018 |
| | | | EA | 201800503 A1 | 28-02-2019 |
| | | | EP | 3222662 A1 | 27-09-2017 |
| | | | EP | 3433316 A1 | 30-01-2019 |
| | | | JP | 6742428 B2 | 19-08-2020 |
| | | | JP | 2019511594 A | 25-04-2019 |
| | | | WO | 2017162417 A1 | 28-09-2017 |
| WO 2018099816 | A1 | 07-06-2018 | CA | 3044157 A1 | 07-06-2018 |
| | | | CN | 110023085 A | 16-07-2019 |
| | | | EP | 3548282 A1 | 09-10-2019 |
| | | | JP | 2020513430 A | 14-05-2020 |
| | | | US | 2020095483 A1 | 26-03-2020 |
| | | | WO | 2018099816 A1 | 07-06-2018 |
| EP 2644652 | A2 | 02-10-2013 | CN | 103228721 A | 31-07-2013 |
| | | | EP | 2644652 A2 | 02-10-2013 |
| | | | KR | 20120057544 A | 05-06-2012 |
| | | | US | 2013255756 A1 | 03-10-2013 |
| | | | WO | 2012070915 A2 | 31-05-2012 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 104319313 A
- US 2015287845 A1
- WO 2017049798 A1
- WO 2017076629 A1
- WO 2018141672 A1
- WO 2019173262 A1
- US 3236917 A
- US 4639495 A
- US 4950541 A
- US 5194509 A
- WO 2019201934 A1

**Non-patent literature cited in the description**

- Encyclopedia of Polymer Science and Engineering. 1986, vol. 6, 383-410
- Polyethylene: High-pressure. **R. KLIMESCH ; D. LITTMANN ; F.-O. MÄHLING.** Encyclopedia of Materials: Science and Technology. Elsevier Science Ltd, 2001, 7181-7184
- **J. RANDALL.** *Macromol. Sci., Rev. Macromol. Chem. Phys.,* 1989, vol. C29, 201
- Polymer Handbook. Wiley, 1989
- **HEINO, E.L. ; LEHTINEN, A. ; TANNER J. ; SEPPÄLÄ, J. ; NESTE OY.** Rheological characterization of polyethylene fractions. *Porvoo, Finland, Theor. Appl. Rheol., Proc. Int. Congr. Rheol, 11th,* 1992, vol. 1, 360-362
- **HEINO, E.L.** The influence of molecular structure on some rheological properties of polyethylene. *Borealis Polymers Oy, Porvoo, Finland, Annual Transactions of the Nordic Rheology Society,* 1995
- Definition of terms relating to the non-ultimate mechanical properties of polymers. *Pure & Appl. Chem.,* 1998, vol. 70 (3), 701-754